# EUROPÄISCHE PATENTSCHRIFT

(11) **EP 0 725 404 B1**
(45) Veröffentlichungstag und Bekanntmachung des Hinweises auf die Patenterteilung: **26.09.2001**
(21) Anmeldenummer: 96200159.0
(22) Anmeldetag: 23.01.1996
(51) Int. Cl.: G11C 27/04

(54) **Verzögerungsschaltung**
Delay circuit
Circuit de délai

(30) Priorität: 04.02.1995 DE 19503782
(43) Veröffentlichungstag der Anmeldung: 07.08.1996
(73) Patentinhaber: Philips Corporate Intellectual Property GmbH, 52064 Aachen (DE); Koninklijke Philips Electronics N.V., 5621 BA Eindhoven (NL)
(72) Erfinder: Struck, Sönke, D-22335 Hamburg (DE)
(74) Vertreter: von Laue, Hanns-Ulrich, Dipl.-Ing.

(56) Entgegenhaltungen:
- DE-A- 4 242 201
- US-A- 4 821 299
- US-A- 5 313 438

## Beschreibung

Die Erfindung betrifft eine Verzögerungsschaltung mit wenigstens zwei Speicherzellen, welche je ein kapazitives Speicherelement, einen Schreibtransistor, mittels dessen eine zu verzögernde Information aus einer Schreibleitung in das kapazitive Speicherelement einschreibbar ist, und einen Lesetransistor aufweisen, mittels dessen eine Information aus dem kapazitiven Speicherelement auf eine Leseleitung auslesbar ist, und mit einer mittels eines ersten Steuertaktes getakteten Steueranordnung, welcher eingangsseitig ein Steuersignal zugeführt wird und welche miteinander gekoppelte Steuerschaltungen aufweist, von denen jeweils eine je einer Speicherzelle zugeordnet ist, wobei mittels des Steuersignals jeder Steuerschaltung der Lesetransistor der zugeordneten Speicherzelle und mittels des Ausgangssignals jeder Steuerschaltung der Schreibtransistor der zugeordneten Speicherzelle ansteuerbar ist.

Verzögerungsschaltungen dieser Art sind aus der EP 383 387 bekannt. Sie haben u.a. in der Videotechnik ein breites Anwendungsgebiet und werden z.B. zur Realisierung von Kammfiltern, zur Implementation von Rausch-Reduktions-Algorithmen und zur Farbdekodierung eingesetzt. Charakteristisch für diese Verzögerungsschaltungen ist, daß der Ausgang einer Steuerschaltung mit dem ersten Takt gleichzeitig den Schreibtransistor der der Steuerschaltung zugeordneten Speicherzelle und den Lesetransistor der nachgeschalteten Speicherzelle ansteuert. Beim Entwurf derartiger Verzögerungsschaltungen ist daher insbesondere darauf zu achten, daß bei der gleichzeitigen Ansteuerung der Schreib- und Lesetransistoren keine Unsymmetrien durch unterschiedliche Laufzeiten des Steuersignals entstehen.

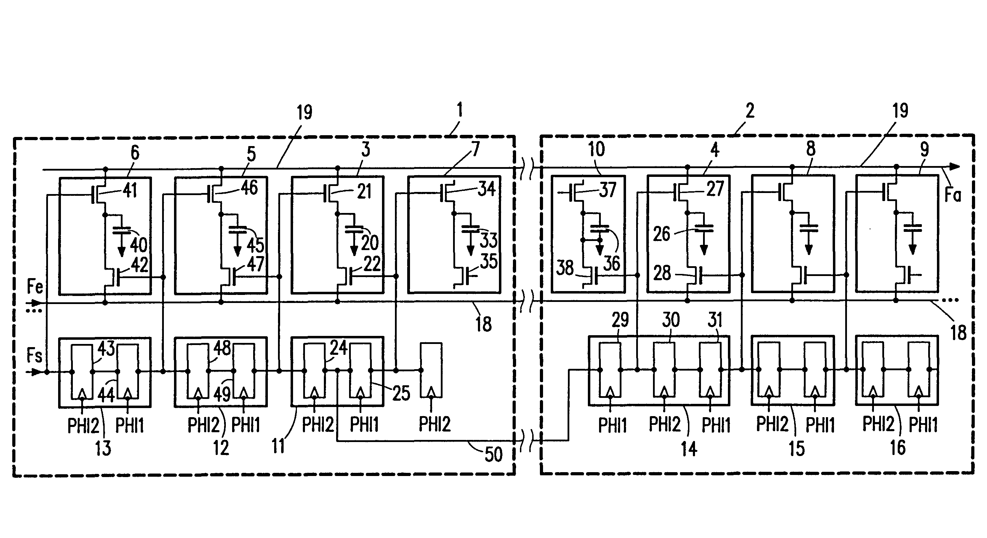

Bei Verzögerungsschaltungen, die als monolitisch integrierte Schaltungen realisiert werden, werden die einzelnen Speicherzellen in gleicher Orientierung auf dem Siliziumkristall angeordnet, und es ergeben sich lange schmale Reihen. Die Anzahl der Speicherzellen, die auf einem Siliziumkristall angeordnet werden können, läßt sich dadurch erhöhen, daß mehrere Reihen von Speicherzellen auf einem Siliziumkristall vorgesehen werden. Eine solche Anordnung zeigt Fig. 4 der EP 383 387. Bei dieser Anordnung tritt jedoch beim Übergang von der letzten Speicherzelle einer ersten Reihe auf die erste Speicherzelle der dieser nachgeschalteten Reihe das Problem auf, daß die Laufzeiten des Steuersignals für die Ansteuerung des Schreibtransistors der letzten Speicherzelle der ersten Reihe und des Lesetransistors der ersten Speicherzelle der nachgeschalteten Reihe deutlich verschieden sind. Diese unsymmetrische Ansteuerung der Schreib- bzw. Lesetransistoren führt in der Videotechnik zu sichtbaren Bildstörungen. Das gleiche Problem tritt z.B. bei der Realisierung eines Ringlaufes auf, bei dem der Ausgang der Steuerschaltung der letzten Speicherzelle einer Verzögerungsschaltung der im Oberbegriff beschriebenen Art auf den Eingang der Steueranordnung der Verzögerungsschaltung gekoppelt ist. Die gleichzeitige Ansteuerung des Schreibtransistors der letzten Speicherzelle und des Lesetransistors der ersten Speicherzelle ist bisher nicht möglich.

Es ist Aufgabe der Erfindung, für eine solche Verzögerungsschaltung eine Möglichkeit zu schaffen, örtlich voneinander entfernt liegende Schreib- und Lesetransistoren gleichzeitig ohne Laufzeitunterschied anzusteuern und damit die angesprochenen Problemstellen störungsfrei zu realisieren.

Diese Aufgabe wird erfindungsgemäß dadurch gelöst, daß jede Steuerschaltung ein erstes und ein diesem nachgeschaltetes zweites Steuerelement aufweist, daß diejenigen Steuerschaltungen ein drittes, dem ersten Steuerelement vorgeschaltetes Steuerelement aufweisen, deren vorgeschaltete Steuerschaltung örtlich entfernt angeordnet ist, daß den dritten Steuerelementen eingangsseitig das Ausgangssignal des ersten Steuerelementes der jeweils vorgeschalteten, räumlich entfernt angeordneten Steuerschaltung zugeführt wird, und daß die ersten Steuerelemente der Steuerschaltungen von dem ersten Takt und die zweiten und dritten Steuerelemente der Steuerschaltungen von einem zweiten Takt getaktet werden.

Der erste und der zweite Takt sind zeitlich gegeneinander verschoben und nicht koinzident. Ist eine zweite Speicherzelle einer ersten Speicherzelle nachgeschaltet und örtlich entfernt angeordnet, so wird die am Eingang der Steuerschaltung der ersten Speicherzelle anliegende Steuerinformation mit dem ersten Takt an den Ausgang des ersten Steuerelementes der ersten Steuerschaltung und mit einer Laufzeit verzögert an den Eingang der örtlich entfernt angeordneten Steuerschaltung der zweiten Speicherzelle geführt. Anschließend wird die Steuerinformation mit dem zweiten Takt gleichzeitig ohne Laufzeitunterschied an den Ausgang der Steuerschaltung der ersten Speicherzelle, welcher den Schreibtransistor der ersten Speicherzelle ansteuert, und an den Ausgang des dritten Steuerelementes der zweiten Speicherzelle, welcher den Lesetransistor der zweiten Speicherzelle ansteuert, geführt. Somit wird die genau gleichzeitige Ansteuerung des Schreibtransistors der ersten Speicherzelle und des Lesetransistors der zweiten, örtlich entfernt angeordneten Speicherzelle verwirklicht. Somit lassen sich die oben genannten Problemstellen störungsfrei realisieren.

Gemäß einer vorteilhaften Ausgestaltung der Erfindung ist vorgesehen, daß der Ausgang des zweiten Steuerelementes derjenigen Steuerschaltungen, deren nachgeschaltete Steuerschaltung räumlich entfernt angeordnet ist und der Ausgang des dritten Steuerelementes der jeweils nachgeschalteten, örtlich entfernt angeordneten Steuerschaltung jeweils mit einer zusätzlichen, nicht zum Verzögern der Information vorgesehenen Speicherzelle gekoppelt sind.

Bei örtlich nebeneinander angeordneten Speicherzellen ist jeder Ausgang der Steuerschaltungen mit dem Schreibtransistor der der Steuerschaltung zugeordneten Speicherzelle und mit dem Lesetransistor der nachgeschalteten Speicherzelle gekoppelt. Somit wird die Ausgangslast jeder Steuerschaltung durch zwei Speicherzellen gebildet. Damit die Ausgangslast der Steuerschaltung einer ersten Speicherzelle und die Ausgangslast des dritten Steuerelementes einer der ersten Speicherzelle nachgeschalteten und örtlich entfernt angeordneten Speicherzelle identisch der Ausgangslast der Steuerschaltungen der übrigen, nebeneinander angeordneten Speicherzellen ist, sind der Ausgang der Steuerschaltung der ersten Speicherzelle und der Ausgang des dritten Steuerelementes der zweiten örtlich entfernt angeordneten Speicherzelle jeweils mit einer zusätzlichen Speicherzelle gekoppelt. Diese zusätzlichen Speicherzellen sind nicht zum Verzögern der Information vorgesehen und dienen nur dazu, dem Ausgang der Steuerschaltung der ersten Speicherzelle und den Ausgang des dritten Steuerelementes der zweiten, örtlich entfernt angeordneten Speicherzelle eine symmetrische Ausgangslast zu liefern.

Gemäß einer weiteren vorteilhaften Ausgestaltung der Erfindung ist vorgesehen, daß eine erste Gruppe von Speicherzellen in einem ersten Bereich und eine zweite Gruppe von Speicherzellen in einem zweiten, örtlich entfernt liegendem Bereich angeordnet ist, und daß das Ausgangssignal des ersten Steuerelementes der Steuerschaltung der letzten Speicherzelle der ersten Gruppe das Eingangssignal der Steuerschaltung der ersten Speicherzelle der zweiten Gruppe darstellt.

Die erste Gruppe ist z.B. eine Anzahl aneinander gereihter Speicherzellen auf einem Siliziumkristall, die zweite Gruppe eine weitere Anzahl aneinandergereihter Speicherzellen auf demselben Siliziumkristall, wobei die zweite Gruppe der ersten Gruppe nachgeschaltet werden soll. Der Übergang von der letzten Speicherzelle der ersten Gruppe auf die erste Speicherzelle der zweiten Gruppe läßt sich gemäß der Erfindung störungsarm realisieren.

Gemäß einer weiteren vorteilhaften Ausgestaltung der Erfindung ist vorgesehen, daß der Steueranordnung eingangsseitig das Ausgangssignal der Steueranordnung zugeführt wird.

Mit einer solchen Verzögerungsschaltung läßt sich z.B. ein Ringlauf störungsarm realisieren. Eine Steuerinformation durchläuft dabei nacheinander die seriell geschalteten Steuerschaltungen einer Anzahl von Speicherzellen, wird vom Ausgang der letzten Steuerschaltung auf den Eingang der ersten Steuerschaltung gekoppelt und durchläuft erneut die seriell geschalteten Steuerschaltungen. Die erste und die letzte Speicherzelle dieser Ringleitung sind dabei gemäß der Erfindung störungsarm ausgeführt.

Verzögerungschaltungen gemäß der Erfindung können vorteilhaft zur Realisierung von Signalverarbeitungsschaltungen in Videorecordern oder Fernsehern verwendet werden. In Videorecordern können insbesondere Rausch-Reduktionschaltungen, Schaltungen zur Dropout-Kompensation und Chrominanz-Kammfilter und in Fernsehern Kammfilter zur Signaltrennung und Schaltungen zur Farbdekodierung realisiert werden.

Ein Ausführungsbeispiel der Erfindung wird nachfolgend anhand der einzigen Figur der Zeichnung näher erläutert.

Verzögerungsschaltungen haben die Aufgabe, ein ihnen am Eingang zugeführtes Signal um eine vorgebbare Zeit verzögert als Ausgangssignal zur Verfügung zu stellen.

Sie können z.B. mittels kapazitiven Speicherelementen realisiert werden, die nacheinander dadurch mit Abtastwerten eines Signals beschrieben werden, daß Einschreibschalter während kurzer Zeit geschlossen werden, wobei die Abtastwerte eine zu dem Schließzeitpunkt des betreffenden Einschreibschalters auftretende Amplitude des Videosignals darstellen. Eine vorgebbare Verzögerungszeit später werden die kapazitiven Speicherelement nacheinander dadurch ausgelesen, daß ein Ausleseschalter während kurzer Zeit geschlossen wird. Diese Technik wird als Switched-Capicitor-Technik bezeichnet.

Insbesondere in der Videotechnik ist es wichtig, Unsymmetrien bei der Ansteuerung der Schalter zu vermeiden, da diese sich als Bildstörungen bemerkbar machen.

Die einzige Figur der Zeichnung zeigt einen Ausschnitt aus einer Verzögerungsschaltung, welche aus einer ersten Gruppe 1 und einer zweiten Gruppe 2 jeweils reihenförmig aneinandergereihter Speicherzellen besteht. Die Speicherzellen der Gruppen 1 und 2 sind jeweils unmittelbar nebeneinander reihenförmig angeordnet, wobei eine Speicherzelle 4 der zweiten Gruppe 2 örtlich entfernt, d.h. in bedeutend größerer Entfernung als unmittelbar nebeneinander angeordnete Speicherzellen jeweils einer Gruppe, von einer Speicherzelle 3 der ersten Gruppe 1 angeordnet ist. Auf einem Siliziumkristall beispielsweise werden Speicherzellen in langen schmalen Reihen angeordnet, wobei mehrere Reihen unter- bzw. übereinander angeordnet sind. Die erste Gruppe 1 könnte z.B. eine erste Reihe von Speicherzellen auf einem Siliziumkristall sein, die zweite Gruppe 2 eine über bzw. unter der ersten Reihe angeordnete zweite Reihe von Speicherzellen sein.

Die Gruppe 1 weist außer der Speicherzelle 3 noch drei dargestellte Speicherzellen 5, 6 und 7 sowie eine Anzahl weiterer, nicht dargestellter und durch Punkte angedeutete Speicherzellen auf. Entsprechend weist die Gruppe 2 neben der Speicherzelle 4 noch dargestellte Speicherzellen 8, 9 und 10 sowie eine Anzahl weiterer nicht dargestellter und durch Punkte angedeuteter Speicherzellen auf.

Jeder Speicherzelle, ausgenommen der Speicherzellen 7 und 10, ist eine Steuerschaltung zugeordnet. In der ersten Gruppe sind den Speicherzellen 3, 5 und 6 die Steuerschaltungen 11, 12 und 13 sowie in der zweiten Gruppe den Speicherzellen 4, 8 und 9 die Steuerschaltungen 14, 15 und 16 zugeordnet. Auch den nicht dargestellten Speicherzellen der Gruppen 1 und 2 ist jeweils eine Steuerschaltung zugeordnet.

Ein Eingangssignal Fₑ wird den Speicherzellen auf einer Schreibleitung 18 zugeführt und das verzögerte Ausgangssignal Fₐ auf einer Leseleitung 19 abgeführt. Die nicht dargestellten Steuerschaltungen der ersten Gruppe sowie die Steuerschaltungen 13, 12 und 11 der ersten Gruppe sind seriell miteinander verschaltet. Ebenso sind die Steuerschaltungen 14, 15 und 16 der zweiten Gruppe sowie die nicht dargestellten Steuerschaltungen der zweiten Gruppe seriell miteinander verschaltet. Dem Eingang der ersten Steuerschaltung der ersten Gruppe 1 wird ein Steuersignal Fₛ zugeführt.

Die Speicherzelle 3 weist eine Speicherkapazität 20, einen Schreibtransistor 22 und einen Lesetransistor 21 auf. Die der Speicherzelle 3 zugeordnete Steuerschaltung 11 weist zwei, seriell verschaltete Steuerelemente 24 und 25 auf. Die Steuerschaltungen 12, 13, 15 und 16 sowie die nicht dargestellten Steuerschaltungen weisen ebenfalls jeweils zwei Steuerelemente auf.

Der Eingang der Steuerschaltung 11 ist auf die Steuerelektrode des Lesetransistors 21 gekoppelt, dessen eine Durchgangselektrode mit der Leseleitung 19 und dessen andere Durchgangselektrode mit einer Elektrode der Speicherkapazität 20 und mit einer Durchgangselektrode des Schreibtransistors 22 gekoppelt ist. Die andere Elektrode der Speicherkapazität 20 ist mit Bezugspotential gekoppelt. Das Ausgangssignal der Steuerschaltung 11 ist mit der Steuerelektrode des Schreibtransistors 22 gekoppelt, dessen andere Durchgangselektrode mit der Schreibleitung 18 gekoppelt ist. Ferner ist der Verbindungspunkt der Steuerelemente 24 und 25 mit dem Eingang der der Speicherzelle 4 zugeordneten Steuerschaltung 14 gekoppelt.

Die Speicherzelle 4 weist eine Speicherkapazität 26, einen Lesetransistor 27 und einen Schreibtransistor 28 auf. Die der Speicherzelle 4 zugeordnete Steuerschaltung 14 weist drei seriell geschaltete Steuerelemente 29, 30 und 31 auf. Der Ausgang der Steuerschaltung 14 ist mit der Steuerelektrode des Schreibtransistors 28 gekoppelt, dessen eine Durchgangselektrode mit der Schreibleitung 18 und dessen andere Durchgangselektrode mit einer Elektrode der Speicherkapazität 26 und mit einer Durchgangselektrode des Lesetransistors 27 gekoppelt ist. Die andere Elektrode der Speicherkapazität 26 ist mit Bezugspotential gekoppelt. Die zweite Durchgangselektrode des Lesetransistors 27 ist mit der Leseleitung 19 und dessen Steuerelektrode mit dem Verbindungspunkt der Steuerelemente 29 und 30 der Steuerschaltung 14 gekoppelt.

Die Speicherzellen 7 und 10 sind nicht zum Verzögern des Eingangssignals Fₑ vorgesehen und dienen nur dazu, dem Ausgang der Steuerschaltung 11 und dem Ausgang des Steuerelementes 29 eine symmetrische Ausgangslast zu liefern. Die Speicherzelle 7 weist eine Speicherkapazität 33 auf, deren beide Elektroden mit Bezugspotential gekoppelt sind. Ferner weist die Speicherzelle 7 einen Lesetransistor 34 und einen Schreibtransistor 35 auf, deren eine Durchgangselektrode jeweils mit Bezugspotential und deren andere Durchgangselektrode hochohmig mit Bezugspotential gekoppelt ist. Die Steuerelektrode des Transistors 34 ist mit dem Ausgang der Steuerschaltung 11 gekoppelt, die Steuerelektrode von Transistor 35 ist hochohmig mit Bezugspotential gekoppelt. Entsprechend weist die Speicherzelle 10 eine Speicherkapazität 36 auf, deren beide Elektroden mit Bezugspotential gekoppelt sind. Ferner weist die Speicherzelle 10 einen Lesetransistor 37 und einen Schreibtransistor 38 auf, deren eine Durchgangselektrode jeweils mit Bezugspotential und deren andere Durchgangselektrode hochohmig mit Bezugspotential gekoppelt ist. Die Steuerelektrode des Transistors 38 ist mit dem Ausgang des Steuerelementes 29 der Steuerschaltung 14 gekoppelt, die Steuerelektrode von Transistor 37 ist hochohmig mit Bezugspotential gekoppelt. Die Speicherzellen 5, 6, 8 und 9 sowie die nicht dargestellten, durch Punkte angedeuteten Speicherzellen sind entsprechend den Speicherzellen 3 und 8 aufgebaut und verschaltet. Die ersten Steuerelemente der Steuerschaltungen 11, 12, 13, 15 und 16 sowie der nicht dargestellten Steuerschaltungen werden jeweils von einem Taktsignal PHI 2, die nachfolgenden zweiten Steuerelemente von einem Taktsignal PHI 1 gesteuert. Die Steuerelemente 29 und 31 werden von dem Taktsignal PHI 1 und das Steuerelement 30 von dem Taktsignal PHI 2 gesteuert. Das Taktsignal PHI 1 und das Taktsignal PHI 2 sind zeitlich gegeneinander verschoben und nicht koinzident. Die Steuerinformation des Steuersignals Fₛ wird jeweils mit der positiven Taktflanke des das jeweilige Steuerelement steuernden Taktsignals vom Eingang des jeweiligen Steuerelementes an dessen Ausgang übertragen.

Nachfolgend wird die Funktionsweise der Verzögerungsschaltung anhand eines konkreten Beispiels erläutert. Am Eingang der Steuerschaltung 13 liege die sich periodisch wiederholende Bitfolge "1010" an, das Eingangssignal Fₑ auf der Schreibleitung 18 sei ein Sinussignal bestimmter Frequenz. Mit der positiven Flanke des Taktsignals PHI 2 wird die Steuerinformation "1" des Steuersignals Fₛ an den Ausgang des Steuerelementes 43, mit der positiven Flanke des nachfolgenden Taktsignals PHI 1 an den Ausgang des Steuerelementes 44 geschaltet. Damit wird der momentane Wert des Sinussignals auf der Schreibleitung 18 mittels des Schreibtransistors 42 in das kapazitive Speicherelement 40 eingeschrieben und gleichzeitig der im kapazitiven Speicherelement 45 gespeicherte Wert mittels des Lesetransistors 46 auf die Leseleitung 19 ausgelesen. Gleichzeitig wird an den Eingang des Steuerelementes 43 die Steuerinformation "0" geschaltet. Mit der nächsten positiven Flanke des Taktsignals PHI 2 wird die Steuerinformation "0" an den Ausgang des Steuerelementes 43 und die Steuerinformation "1" an den Ausgang des Steuerelementes 48 übertragen und mit der nächsten positiven Taktflanke des Taktsignals PHI1 die Steuerinformation "0" an den Ausgang der Steuerschaltung 13 und die Steuerinformation "1" an den Ausgang der Steuerschaltung 12 übertragen. Damit werden die Steuerelektroden der Transistoren 47 und 21 angesteuert, die Steuerelektroden der Transistoren 42 und 46 jedoch nicht. Damit wird der momentane Wert des Sinussignals auf der Schreibleitung 18 mittels des Schreibtransistors 47 in das kapazitive Speicherelement 45 eingelesen und gleichzeitig der im kapazitiven Speicherelement 20 gespeicherte Wert mittels des Lesetransistors 21 auf die Leseleitung 19 ausgelesen. Gleichzeitig wird an den Eingang der Steuerschaltung 13 die Steuerinformation "1" übertragen und der im kapazitiven Speicherelement 40 gespeicherte Wert wird mittels des Lesetransistors 41 auf die Leseleitung 19 ausgelesen.

Mit der sich periodisch wiederholenden Bitfolge "1010" des Steuersignals werden somit die momentanen Werte des Sinussignals auf der Schreibleitung 18, die mit einer positiven Taktflanke des Taktsignals PHI1 in ein kapazitives Speicherelement eingeschrieben werden,mit der übernächsten positiven Taktflanke des Taktsignals PHI1 wieder auf die Leseleitung 19 ausgelesen. Mit einer sich periodisch wiederholenden Bitfolge "100100" beispielsweise würde der mit einer positiven Taktflanke des Taktsignals PHI1 in ein kapazitives Speicherelement eingeschriebene Wert mit der nachfolgend dritten positiven Taktflanke des Taktsignals PHI1 ausgelesen.

Wenn am Eingang des zweiten Steuerelementes einer Steuerschaltung die Steuerinformation "1" anliegt, so wird diese mit der positiven Flanke des Taktsignals PHI 1 an den Ausgang der Steuerschaltung übertragen und steuert gleichzeitig den Schreibtransistor der der Steuerschaltung zugeordneten Speicherzelle und den Lesetransistor der nachfolgenden Speicherzelle an. Diese gleichzeitige Ansteuerung ist insbesondere in der Videotechnik von großer Bedeutung, da sich Unsymmetrien bei der Ansteuerung als Bildstörungen bemerkbar machen würden. Probleme treten bisher insbesondere dann auf, wenn die gleichzeitig anzusteuernden Schreib- und Lesetransistoren örtlich entfernt voneinander angeordnet sind. Würde man beispielsweise den Schreibtransistor 22 und den Lesetransistor 27, die örtlich entfernt voneinander angeordnet sind, beide vom Ausgang der Steuerschaltung 11 ansteuern, so würde der Lesetransistor 27 um eine von der örtlichen Entfernung abhängige Laufzeit verzögert gegenüber dem Schreibtransistor 22 angesteuert.

Die in der Fig. dargestellte Schaltungsanordnung - ermöglicht es, auch örtlich entfernt voneinander liegende Schreib- und Lesetransistoren gleichzeitig ohne Laufzeitunterschied anzusteuern. Hierzu werden die örtlich entfernt voneinander angeordneten Speicherzellen 3 und 4 näher betrachtet. Liegt beispielsweise am Eingang der Steuerschaltung 11 die Steuerinformation 1 an, so wird diese mit der positiven Taktflanke des Taktsignals PHI 2 an den Ausgang des Steuerelementes 24 geschaltet. Außerdem wird diese Steuerinformation mittels der Leitung 50 um eine Laufzeit verzögert an den Eingang des Steuerelementes 29 der Steuerschaltung 14 übertragen. Mit der nächsten positiven Taktflanke des Taktsignals PHI 1 wird diese Steuerinformation dann gleichzeitig ohne Laufzeitunterschied an den Ausgang der Steuerelemente 25 und 29 übertragen und der Schreibtransistor 22 der Speicherzelle 3 und der Lesetransistor 27 der örtlich entfernt angeordneten Speicherzelle 4 werden gleichzeitig ohne Laufzeitunterschied angesteuert.

Die Ausgangslast der Steuerschaltungen 12, 13, 14, 15 und 16 sowie der weiteren, nicht dargestellten Steuerschaltungen werden durch jeweils zwei Speicherzellen gebildet. Die Ausgangslast der Steuerschaltung 13 beispielsweise wird durch die Speicherzellen 5 und 6 gebildet. Unsymmetrien infolge unterschiedlicher Ausgangslasten der einzelnen Steuerschaltungen führen beispielsweise in der Videotechnik zu Bildstörungen. Damit die Ausgangslast der Steuerschaltung 11 und die Ausgangslast des Steuerelementes 29 der Steuerschaltung 14 identisch der Ausgangslast der übrigen Steuerschaltungen sind, sind die Speicherzellen 7 und 10 vorgesehen. Diese dienen dazu, den Ausgängen der Steuerschaltung 11 und des Steuerelementes 29 der Steuerschaltung 14 eine symmetrische Ausgangslast zu liefern. Sie werden jedoch nicht zum Verzögern des Eingangssignals Fₑ verwendet und sind daher nicht mit der Schreibleitung 18 und der Leseleitung 19 gekoppelt. Daher können sie als "Dummy-Speicherzellen" bezeichnet werden.

## Patentansprüche

1. Verzögerungsschaltung mit wenigstens zwei Speicherzellen (3,4,5,6,8,9), welche je ein kapazitives Speicherelement (20,26,40,45), einen Schreibtransistor (22,28,42,47), mittels dessen eine zu verzögernde Information aus einer Schreibleitung (18) in das kapazitive Speicherelement (20,26,40,45) einschreibbar ist, und einen Lesetransistor (21,27,41,46) aufweisen, mittels dessen eine Information aus dem kapazitiven Speicherelement (20,26,40,45) auf eine Leseleitung (19) auslesbar ist, und mit einer mittels eines ersten Steuertaktes getakteten Steueranordnung, welcher eingangsseitig ein Steuersignal zugeführt wird und welche miteinander gekoppelte Steuerschaltungen ((11,12,13,14,15,16) aufweist, von denen jeweils eine je einer Speicherzelle (3,4,5,6,8,9) zugeordnet ist, wobei mittels des Steuersignals jeder Steuerschaltung (11,12,13,14,15,16) der Lesetransistor (21,27,41,46) der zugeordneten Speicherzelle (3,4,5,6,8,9) und mittels des Ausgangssignals jeder Steuerschaltung (11,12,13,14,15,16) der Schreibtransistor (22,28,42,47) der zugeordneten Speicherzelle ansteuerbar ist,
**dadurch gekennzeichnet, daß** jede Steuerschaltung (11,12,13,14,15,16) ein erstes (43,48,24,30) und ein diesem nachgeschaltetes zweites (44,49,25,31) Steuerelement aufweist, diejenigen Steuerschaltungen (14) ein drittes, dem ersten Steuerelement (30) vorgeschaltetes Steuerelement (29) aufweisen, deren vorgeschaltete Steuerschaltung (11) örtlich entfernt angeordnet ist, daß den dritten Steuerelementen (29) eingangsseitig das Ausgangssignal des ersten Steuerelementes (24) der jeweils vorgeschalteten, räumlich entfernt angeordneten Steuerschaltung (11) zugeführt wird, und daß die ersten Steuerelemente (43,48,24,30) der Steuerschaltungen (11,12,13,14,15,16) von dem ersten Takt und die zweiten (44,49,25,31) und dritten (29) Steuerelemente der Steuerschaltungen (11,12,13,14,15,16) von einem zweiten Takt getaktet werden.

2. Verzögerungsschaltung nach Anspruch 1,
**dadurch gekennzeichnet, daß** der Ausgang des zweiten Steuerelementes (25) derjenigen Steuerschaltungen (11), deren nachgeschaltete Steuerschaltung (14) räumlich entfernt angeordnet ist, und der Ausgang des dritten Steuerelementes (29) der dieser nachgeschalteten, örtlich entfernt angeordneten Steuerschaltung (14) jeweils mit einer zusätzlichen, nicht zum Verzögern der Information vorgesehenen Speicherzelle (7,10) gekoppelt sind.

3. Verzögerungsschaltung nach Anspruch 1 oder 2,
**dadurch gekennzeichnet, daß** der Ausgang des zweiten Steuerelementes (25) derjenigen Steuerschaltungen (11), deren nachgeschaltete Steuerschaltung (14) räumlich entfernt angeordnet ist, mit dem Lesetransistor (34) einer zusätzlichen, nicht zum Verzögern der Information vorgesehenen Speicherzelle (7) und der Ausgang des dritten Steuerelementes (29) der dieser nachgeschalteten, örtlich entfernt angeordneten Steuerschaltung (14) mit dem Schreibtransistor (38) einer zusätzlichen, nicht zum Verzögern der Information vorgesehen Speicherzelle (10) gekoppelt ist.

4. Verzögerungsschaltung nach Anspruch 1, 2 oder 3,
**dadurch gekennzeichnet, daß** eine erste Gruppe von Speicherzellen (1) in einem ersten Bereich und eine zweite Gruppe von Speicherzellen (2) in einem zweiten, örtlich entfernt liegendem Bereich angeordnet ist, und daß das Ausgangssignal des ersten Steuerelementes (24) der Steuerschaltung (11) der letzten Speicherzelle (3) der ersten Gruppe (1) das Eingangssignal der Steuerschaltung (14) der ersten Speicherzelle (4) der zweiten Gruppe (2) darstellt.

5. Verzögerungsschaltung nach einem der Ansprüche 1 bis 4,
**dadurch gekennzeichnet, daß** die Steuerschaltungen (11,12,13,14,15,16) seriell geschaltet sind.

6. Verzögerungsschaltung nach einem der Ansprüche 1 bis 5,
**dadurch gekennzeichnet, daß** der Steueranordnung eingangsseitig ein externes Steuersignal zugeführt wird.

7. Verzögerungsschaltung nach einem der Ansprüche 1 bis 5,
**dadurch gekennzeichnet, daß** der Steueranordnung eingangsseitig das Ausgangssignal der Steueranordnung zugeführt wird.

8. Verzögerungsschaltung nach einem der Ansprüche 1 bis 5,
**dadurch gekennzeichnet, daß** der Steueranordnung eingangsseitig das Ausgangssignal einer der Steuerschaltungen (11,12,13,14,15,16) zugeführt wird.

9. Verwendung der Verzögerungschaltung nach einem der Ansprüche 1 bis 8 zur Realisierung von Signalverarbeitungschaltungen eines Videorecorders, insbesondere für Rausch-Reduktionschaltungen, Schaltungen zur Dropout-Kompensation oder für Chrominanz-Kammfilter.

10. Verwendung der Verzögerungschaltung nach einem der Ansprüche 1 bis 8 zur Realisierung von Signalverarbeitungschaltungen eines Fernsehers, insbesondere für Kammfilter zur Signaltrennung oder für Schaltungen zur Farbdekodierung.

## Claims

1. A delay circuit having at least two memory cells (3, 4, 5, 6, 8, 9) each comprising a capacitive memory element (20, 26, 40, 45), a write transistor (22, 28, 42, 47) by means of which information to be delayed can be written from a write line (18) into the capacitive memory element (20, 26, 40, 45), and a read transistor (21, 27, 41, 46) by means of which information can be read from the capacitive memory element (20, 26, 40, 45) on a read line (19), and having a control arrangement which is clocked by means of a first control clock and whose input receives a control signal and which comprises intercoupled control circuits (11, 12, 13, 14, 15, 16) one of which is associated with a respective memory cell (3, 4, 5, 6, 8, 9), each control circuit (11, 12, 13, 14, 15, 16) of the read transistor (21, 27, 41, 46) of the associated memory cell (3, 4, 5, 6, 8, 9) being controllable by means of the control signal and each control circuit (11, 12, 13, 14, 15, 16) of the write transistor (22, 28, 42, 47) of the associated memory cell being controllable by means of the output signal, **characterized in that** each control circuit (11, 12, 13, 14, 15, 16) has a first control element (43, 48, 24, 30) and a subsequent second control element (44, 49, 25, 31), in that those control circuits (14) whose preceding control circuit (11) is arranged locally remote have a third control element (29) preceding the first control element (30), in that the input of the third control element (29) receives the output signal of the first control element (24) of the preceding, spatially remote control circuit (11), and in that the first control elements (43, 48, 24, 30) of the control circuits (11, 12, 13, 14, 15, 16) are clocked by the first clock and the second (44, 49, 25, 31) and third (29) control elements of the control circuits (11, 12, 13, 14, 15, 16) are clocked by a second clock.

2. A delay circuit as claimed in claim 1, **characterized in that** the output of the second control element (25) of those control circuits (11) whose subsequent control circuit (14) is arranged spatially remote and the output of the third control element (29) of the subsequent locally remote control circuit (14) are coupled to an additional memory cell (7, 10) which is not provided for delaying the information.

3. A delay circuit as claimed in claim 1 or 2, **characterized in that** the output of the second control element (25) of those control circuits (11) whose subsequent control circuit (14) is arranged spatially remote is coupled to the read transistor (34) of an additional memory cell (7) which is not provided for delaying the information, and the output of the third control element (29) of the subsequent locally remote control circuit (14) is coupled to the write transistor (38) of an additional memory cell (10) which is not provided for delaying the information.

4. A delay circuit as claimed in claim 1, 2 or 3, **characterized in that** a first group of memory cells (1) is arranged in a first area and a second group of memory cells (2) is arranged in a second, locally remote area, and in that the output signal of the first control element (24) of the control circuit (11) of the last memory cell (3) of the first group (1) represents the input signal of the control circuit (14) of the first memory cell (4) of the second group (2).

5. A delay circuit as claimed in any one of claims 1 to 4, **characterized in that** the control circuits (11, 12, 13, 14, 15, 16) are serially arranged.

6. A delay circuit as claimed in any one of claims 1 to 5, **characterized in that** the input of the control arrangement receives an external control signal.

7. A delay circuit as claimed in any one of claims 1 to 5, **characterized in that** the input of the control arrangement receives the output signal of the control arrangement.

8. A delay circuit as claimed in any one of claims 1 to 5, **characterized in that** the input of the control arrangement receives the output signal of one of the control circuits (11, 12, 13, 14, 15, 16).

9. Use of the delay circuit as claimed in any one of claims 1 to 8 for realising signal processing circuits of a video recorder, particularly for noise reduction circuits, circuits for drop-out compensation or for chrominance comb filters.

10. Use of the delay circuit as claimed in any one of claims 1 to 8 for realising signal processing circuits of a television receiver, particularly for comb filters for signal separation, or for colour decoding circuits.

## Revendications

1. Circuit retardateur avec au moins deux cellules de mémoire (3, 4, 5, 6, 8, 9) qui présentent respectivement un élément de mémoire capacitif (20, 26, 40, 45), un transistor d'écriture (22, 28, 42, 47) à l'aide duquel une information à retarder peut être enregistrée d'une ligne d'écriture (18) dans l'élément de mémoire capacitif (20, 26, 40, 45) et un transistor de lecture (21, 27, 41, 46) à l'aide duquel une information peut être lue de l'élément de mémoire capacitif (20, 26, 40, 45) sur une ligne de lecture (19) et avec un dispositif de commande cadencé à l'aide d'un premier rythme de commande auquel est amené côté entrée un signal de commande et qui présente des circuits de commande couplés entre eux (11, 12, 13, 14, 15, 16) dont respectivement un est affecté à une cellule de mémoire (3, 4, 5, 6, 8, 9), le transistor de lecture (21, 27, 41, 46) de la cellule de mémoire affectée (3, 4, 5, 6, 8, 9) pouvant être excité à l'aide du signal de commande de chaque circuit de commande (11, 12, 13, 14, 15, 16) et le transistor d'écriture (2, 28, 42, 47) de la cellule de mémoire affectée à l'aide du signal de sortie de chaque circuit de commande (11, 12, 13, 14, 15, 16),
**caractérisé en ce que** chaque circuit de commande (11, 12, 13, 14, 15, 16) présente un premier (43, 48, 24, 30) et un deuxième (44, 49, 25, 31) élément de commande monté en aval de celui-ci, les circuits de commande (14) desquels le circuit de commande (11) est espacé localement présentant un troisième élément de commande (29) monté en amont du premier élément de commande (30), que le signal de sortie du premier élément de commande (24) du circuit de commande (11) espacé localement et respectivement monté en amont est amené côté entrée au troisième élément de commande (29) et que les premiers éléments de commande (43, 48, 24, 30) des circuits de commande (11, 12, 13, 14, 15, 16) sont cadencés par le premier rythme et les deuxième (44, 49, 25, 31) et troisième (29) éléments de commande des circuits de commande (11, 12, 13, 14, 15, 16) par un deuxième rythme.

2. Circuit retardateur selon la revendication 1,
**caractérisé en ce que** la sortie du deuxième élément de commande (25) des circuits de commande (11) desquels le circuit de commande (14) monté en aval est espacé localement et la sortie du troisième élément de commande (29) du circuit de commande (14) espacé localement et monté en aval de celui-ci sont respectivement couplés à une cellule de mémoire (7, 10) supplémentaire non prévue en vue de retarder l'information.

3. Circuit retardateur selon l'une des revendications 1 ou 2,
**caractérisé en ce que** la sortie du deuxième élément de commande (25) des circuits de commande (11) desquels le circuit de commande monté en aval est espacé localement est couplée au transistor de lecture (34) d'une cellule de mémoire (7) supplémentaire non prévue en vue de retarder l'information et la sortie du troisième élément de commande (29) du circuit de commande (14) monté en aval espacé localement de celui-ci est couplée au transistor d'écriture (38) d'une cellule de mémoire (10) supplémentaire non prévue pour retarder l'information.

4. Circuit retardateur selon l'une des revendications 1, 2 ou 3,
**caractérisé en ce qu'**un premier groupe de cellules de mémoire (1) est disposé dans une première zone et un deuxième groupe de cellules de mémoire (2) disposé dans une deuxième zone espacée localement et que le signal de sortie du premier élément de commande (24) du circuit de commande (11) de la dernière cellule de mémoire (3) du premier groupe (1) représente le signal d'entrée du circuit de commande (14) de la première cellule de mémoire (4) du deuxième groupe (2).

5. Circuit retardateur selon l'une des revendications 1 à 4,
**caractérisé en ce que** les circuits de commande (11, 12, 13, 14, 16) sont montés en série.

6. Circuit retardateur selon l'une des revendications 1 à 5,
**caractérisé en ce qu'**au dispositif de commande est amené côté entrée un signal externe.

7. Circuit retardateur selon l'une des revendications 1 à 5,
**caractérisé en ce qu'**au dispositif de commande est amené côté entrée le signal de sortie du dispositif de commande.

8. Circuit retardateur selon l'une des revendications 1 à 5,
**caractérisé en ce qu'**au dispositif de commande est amené côté entrée le signal de sortie d'un des circuits de commande (11, 12, 13, 14, 15,16).

9. Mise en oeuvre du circuit retardateur selon l'une des revendications 1 à 8 en vue de la réalisation de circuits de traitements de signaux d'un magnétoscope, en particulier pour les circuits de réduction du bruit, les circuits de compensation du dropout ou les filtres en peigne de chrominance.

10. Mise en oeuvre du circuit retardateur selon l'une des revendications 1 à 8 en vue de la réalisation de circuits de traitements de signaux d'un téléviseur, en particulier pour les filtres en peigne en vue de la séparation des signaux ou pour les circuits en vue du décodage couleur.
